# FASCICULE DE BREVET EUROPEEN

(11) **EP 4 009 371 B1**
(45) Date de publication et mention de la délivrance du brevet: **04.06.2025**
(21) Numéro de dépôt: 21212160.2
(22) Date de dépôt: 03.12.2021
(51) Int. Cl.: H10B 63/00, H10N 70/20, G11C 13/00

(54) **DISPOSITIF SELECTEUR POUR DISPOSITIF MEMOIRE DE TYPE RESISTIF ET PROCEDE DE FABRICATION ASSOCIE**
AUSWAHLVORRICHTUNG FÜR RESISTIVE SPEICHERVORRICHTUNG UND ENTSPRECHENDES HERSTELLUNGSVERFAHREN
SELECTOR DEVICE FOR RESISTIVE MEMORY DEVICE AND ASSOCIATED MANUFACTURING METHOD

(30) Priorité: 07.12.2020 FR 2012772
(43) Date de publication de la demande: 08.06.2022
(73) Titulaire: Commissariat à l'Energie Atomique et aux Energies Alternatives, 75015 Paris (FR)
(72) Inventeur: NAVARRO, Gabriele, 38254 Grenoble Cedex 09 (FR)
(74) Mandataire: Cabinet Camus Lebkiri

(56) Documents cités:
- US-A1- 2009 067 228
- US-A1- 2011 006 276
- US-A1- 2015 332 766
- US-A1- 2017 062 524
- US-A1- 2020 127 046
- US-B1- 7 035 141

## Description

### DOMAINE TECHNIQUE DE L'INVENTION

Le domaine technique de l'invention est celui des mémoires résistives. Un premier objet de l'invention est un dispositif sélecteur destiné à sélectionner une cellule mémoire résistive. Un deuxième objet de l'invention est un dispositif mémoire intégrant à la fois une fonction de mémoire non volatile et une fonction de sélecteur. Un autre objet de l'invention est un procédé de fabrication du dispositif sélecteur selon l'invention.

### ARRIERE-PLAN TECHNOLOGIQUE DE L'INVENTION

Pour des applications qui nécessitent un stockage de l'information même lorsque la tension est coupée, des mémoires non volatiles de type EEPROM ou FLASH sont classiquement utilisées. Ces mémoires présentent toutefois des inconvénients tels que des temps d'écriture longs, une densité de points mémoire limitée par la taille des transistors utilisés ou encore un nombre de cycles de réécriture limité.

Le développement de nouvelles technologies telles que les mémoires SCM (pour « Storage Class Memories ») permet d'envisager une nouvelle génération d'ordinateurs ayant des performances améliorées et une faible consommation en énergie. Les mémoires non volatiles résistives sont des très bons candidats pour le développement de la technologie SCM et constituent une alternative prometteuse aux mémoires de type FLASH ou EEPROM.

Les mémoires résistives reposent sur l'utilisation d'un milieu actif dont la résistance électrique dépend de la tension électrique appliquée aux bornes du matériau. En d'autres termes une cellule mémoire résistive présente deux états : un état OFF correspondant à un état hautement résistif et un état ON correspondant à un état faiblement résistif. Le milieu actif est inséré entre deux électrodes permettant l'application d'une tension électrique et assurant la lecture et l'écriture de l'état de la cellule mémoire résistive.

Selon le type de matériau actif utilisé, différents types de mémoire résistive peuvent être réalisées : matériaux à changement de phase (mémoires PCRAM ou « Phase Change RAM » également appelée PCM « Phase Change Memory »), à conduction ionique (mémoires CBRAM ou « Conductive Bridging RAM »), à oxydes métalliques (mémoires OxRAM ou « Oxide Resistive RAM »), ferroélectriques (mémoires FERAM ou « Ferroelectric RAM »), magnétiques (mémoires MRAM ou « Magnetic RAM), ou encore magnétiques à transfert de spin (mémoires STTRAM ou « Spin Torque Transfer RAM »).

Pour que les mémoires résistives puissent concurrencer les mémoires standard de type FLASH, il est nécessaire d'augmenter leur scalabilité et leur densité. La scalabilité est liée à la dimension du dispositif : la réduction de la taille du dispositif entraîne la réduction de l'intensité de courant nécessaire à la programmation de la cellule. Par ailleurs, la réduction de la taille de la cellule mémoire peut aussi améliorer la densité en entraînant une augmentation du nombre de dispositifs pour une même surface de puce.

Pour atteindre une densité capable de rivaliser avec les autres technologies de mémoires non volatiles, il est nécessaire de réaliser une intégration dite 3D. Cela nécessite une modification de l'architecture de la mémoire, notamment avec le remplacement du sélecteur standard de type « transistor » par un sélecteur de type « diode » intégré en série avec la cellule de mémoire unitaire. La structure prend donc le nom de « structure crossbar » et l'élément de mémoire unitaire est alors constitué par une cellule de mémoire résistive 1R et un sélecteur de type diode 1D ou 1S pour sélecteur, en série avec la cellule mémoire et disposé entre une électrode supérieure et une électrode inferieure pour former un dispositif 1D1R. Chaque dispositif 1D1R se situe au croisement entre deux lignes de métal (bitline et wordline). Un dispositif 1D1R dans l'ensemble de la structure, peut être lu/programmé avec une polarisation opportune des bitlines et des wordlines.

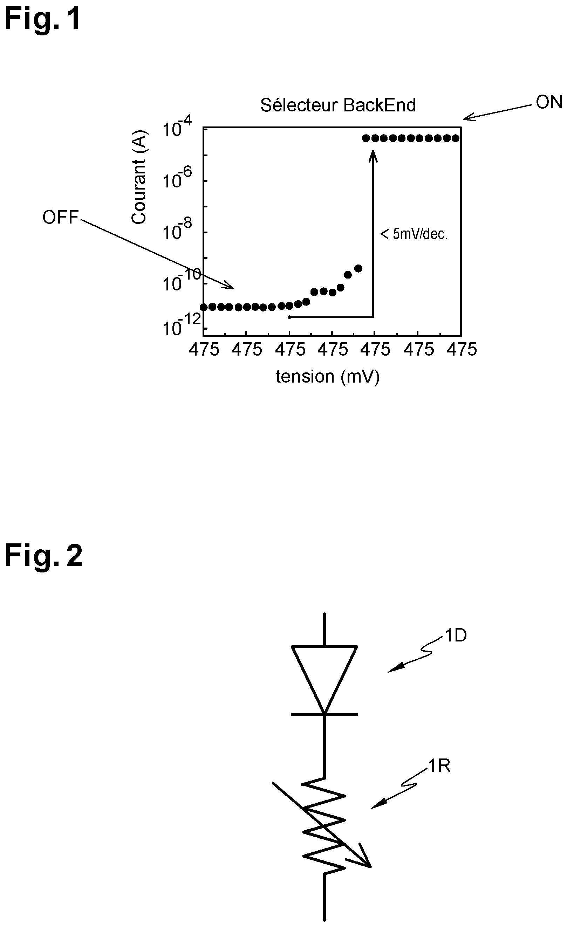

La figure 1 illustre le courant électrique fourni par un dispositif sélecteur en fonction de la tension électrique appliquée à ses bornes. Le dispositif sélecteur possède un premier état, dit « OFF » dans lequel il fournit un très faible courant électrique. Pour des tensions appliquées supérieures à un seuil, ici entre 492mV et 495mV, le dispositif sélecteur bascule dans un état faiblement résistif, ou état « ON », dans lequel il fournit un courant élevé, de manière à alimenter le dispositif avec lequel il est monté en série.

La figure 2 illustre un dispositif de type 1D1R comprenant une cellule mémoire résistive connectée en série à un dispositif sélecteur de type diode. Même si les sélecteurs de type diode ont montré une bonne fiabilité et peuvent supporter un grand nombre de cycles d'activation, nécessaires pour les opérations d'écriture ou de lecture de l'état de la cellule mémoire, ces dispositifs ne sont pas adaptés au développement d'une intégration 3D. En effet les diodes ont généralement un courant dans l'état « ON » qui peut s'avérer trop faible pour programmer efficacement la mémoire résistive. Plus particulièrement, les diodes de type « backend » possèdent des résistances séries très élevées et variables.

Pour cette raison, plusieurs solutions alternatives ont été proposées. L'homme du métier connaît désormais différents types de sélecteur « backend » : à seuil supra-linéaire assisté par champ ou FAST selon la terminologie anglaise « Field Assisted Superlinear Threshold », à conduction électrique mixte ionique-électronique ou MIEC selon la terminologie anglaise « mixed-ionic-electronic-conduction » et notamment les commutateurs ovoniques à seuil ou OTS, selon la terminologie anglaise « Ovonic Threshold Switching ». Ces solutions sont capables de livrer des courants très importants, mais ne garantissent pas la fiabilité du mécanisme de switch, car ce mécanisme engendre intrinsèquement un changement de la structure du matériau (i.e. changement de phase, diffusion d'une électrode, oxydo-réduction d'une électrode, etc.), ce qui produit une progressive détérioration du dispositif.

Dans un sélecteur à l'extrémité arrière de ligne ou « backend » selon la terminologie anglaise, on doit garantir deux opérations fondamentales :
- la programmation de la mémoire 1R en série ;
- la lecture de la mémoire 1R en série.

La programmation de la cellule mémoire requiert généralement un courant supérieur ou égal à 100µA et comporte la bascule « OFF-ON » (de l'état OFF vers l'état ON) du sélecteur pour chaque opération de programmation.

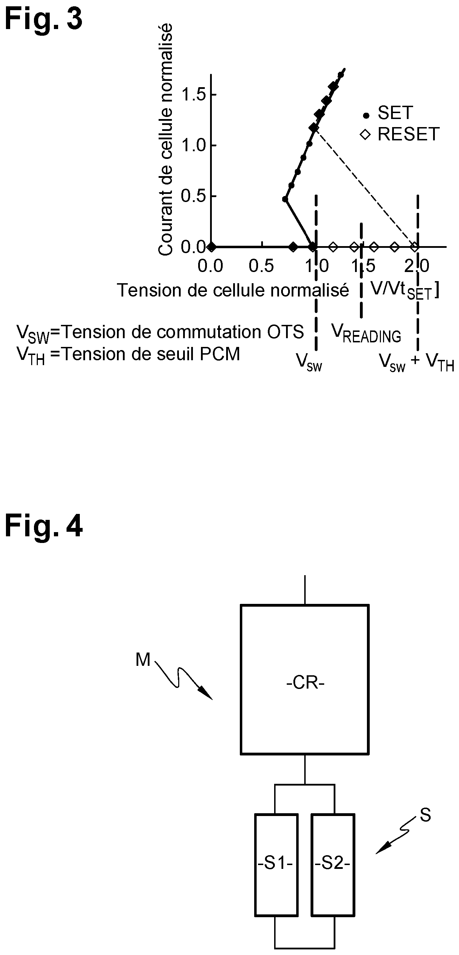

La figure 3 illustre l'opération de lecture d'une cellule mémoire associée à un sélecteur. Un faible courant électrique supérieur ou égal à 1µA est suffisant pour détecter si le dispositif est dans son état faiblement résistif ou état SET ou encore dans son état hautement résistif ou état RESET. En effet, dans un système « crossbar » 1S1R, l'état RESET correspond à une tension de switch du système plus élevée que celle nécessaire si le système se trouve dans l'état SET. La lecture de l'état de la cellule mémoire repose donc sur le principe suivant.

Pour la lecture, il faut un courant électrique faible mais suffisant (> 1µA) pour pouvoir détecter si le dispositif mémoire est tout simplement dans son état SET ou RESET. Dans un système « crossbar » 1D1R (1D pour diode) ou 1S1R (1S est pour « sélecteur »), si la mémoire est dans l'état « RESET » (hautement résistif), la tension de switch globale du système 1S1R est plus importante que celle dans le cas où la mémoire est dans l'état « SET » (faiblement résistif).

Pour lire l'état du dispositif, il suffit donc d'appliquer une tension notée V_{Reading} sur la figure 3. Cette tension est comprise entre la tension seuil du sélecteur 1S et au mieux la somme de la tension de seuil du sélecteur 1S celle de la mémoire 1R dans l'état RESET (Vsw+Vth). Si en appliquant la tension V_{Reading} le courant mesuré est faible, l'état du dispositif est l'état RESET. Si le courant mesuré est élevé, l'état du dispositif est l'état SET.

Il s'ensuit que pendant l'opération de lecture, le sélecteur 1S est soumis à une opération de commutation entre ses deux états au moins pour chaque lecture de type SET. Dans une application standard, le nombre d'opérations de programmation d'un dispositif mémoire peut varier de 10⁴ à 10¹² fois. Au contraire le nombre d'opérations de lecture dépend du type d'application envisagée. La fréquence des opérations de lecture peut être comparable voire des ordres de grandeurs supérieure à celle des opérations de programmation.

L'inconvénient d'un sélecteur backend, est que chaque opération de lecture et de programmation entraîne une détérioration du dispositif et en réduit la durée de vie, tout en réduisant la fiabilité de la cellule mémoire.

Le document US2020/0127046 A1 divulgue un dispositif sélecteur formé par deux diodes sélectrices ou d'autres sélecteurs à deux bornes montés en antiparallèle et disposés côte à côte, destiné à sélectionner une cellule mémoire résistive de façon bipolaire.

Pour atteindre l'intégration 3D des cellules mémoire résistives, il est aujourd'hui nécessaire d'améliorer la fiabilité et la durée de vie des dispositifs de type 1R1S, comprenant une cellule mémoire résistive R et un dispositif sélecteur S assurant la lecture et l'écriture de la cellule mémoire.

### RESUME DE L'INVENTION

L'invention offre une solution aux problèmes évoqués précédemment, en proposant un dispositif sélecteur destiné à sélectionner une cellule mémoire résistive comportant un premier dispositif sélecteur comprenant un premier matériau actif et un deuxième dispositif sélecteur comprenant un deuxième matériau actif, le premier dispositif sélecteur et le deuxième dispositif sélecteur étant connectés en parallèle, selon la revendication 1.

On entend par cellule mémoire résistive un dispositif électrique possédant un premier état hautement résistif ou état OFF ou encore état RESET et un deuxième état faiblement résistif ou état ON ou encore état SET. Une cellule mémoire résistive comprend une première électrode et une deuxième électrode permettant d'appliquer une tension électrique aux bornes d'un matériau actif.

On entend par matériau actif un matériau dont la résistance électrique dépend de la tension électrique appliquée. En d'autres termes, on entend par matériau actif un matériau qui peut passer d'un état hautement résistif à un état faiblement résistif selon la tension appliquée à ses bornes.

Le dispositif sélecteur selon l'invention comprend un premier dispositif sélecteur et un deuxième dispositif sélecteur, le premier et deuxième dispositifs sélecteur étant connectés en parallèle, le premier dispositif sélecteur étant configuré pour fournir un courant électrique adapté à une lecture d'un état de la cellule mémoire résistive et le deuxième dispositif sélecteur étant configuré pour fournir un courant électrique adapté à une écriture d'un état de la cellule mémoire résistive. On entend par connexion en parallèle, une connexion électrique telle que la tension appliquée aux bornes du premier dispositif sélecteur est la même que la tension appliquée aux bornes du deuxième dispositif sélecteur. De plus, le deuxième dispositif sélecteur est agencé pour entourer le premier dispositif sélecteur.

Grâce à l'invention, l'utilisation d'un double dispositif sélecteur permet de repartir les cycles de lecture/écriture parmi les deux dispositifs sélecteurs connectés en parallèle, tout en augmentant le temps de vie ainsi que la fiabilité du dispositif mémoire. En d'autres termes, le deuxième dispositif sélecteur ne sera mis en oeuvre que lors d'une opération d'écriture ou programmation, limitant sa détérioration. Avantageusement, l'utilisation du dispositif selon l'invention, comprenant un dispositif sélecteur formé par le parallèle d'un premier et d'un deuxième dispositif sélecteur permet d'obtenir un dispositif mémoire volatile ayant une grande fiabilité, une durée de vie prolongée et une consommation d'énergie réduite.

Le premier matériau actif possède une première tension de seuil pour le passage d'un courant électrique et le deuxième matériau actif possède une deuxième tension de seuil pour le passage d'un courant électrique, la première tension de seuil étant inférieure à la deuxième tension de seuil. Cela permet d'appliquer une première tension de seuil pour basculer le premier dispositif sélecteur dans son état faiblement résistif, sans modifier l'état du deuxième dispositif sélecteur. Cette condition est donc idéale pour lire l'état de la cellule mémoire tout en utilisant un faible courant électrique et en limitant la consommation d'énergie. Par ailleurs, cette condition évite de modifier l'état de deuxième dispositif sélecteur, car la première tension électrique ne suffit pas pour basculer le deuxième dispositif sélecteur dans son état actif. Le deuxième dispositif sélecteur n'est donc pas détérioré lors d'une opération de lecture, en augmentant la durée de vie du dispositif mémoire.

Le deuxième dispositif sélecteur est utilisé uniquement pour l'opération d'écriture. Dans ce cas, il est nécessaire d'appliquer la deuxième tension électrique de seuil au dispositif sélecteur formé par la mise en parallèle du premier et du deuxième dispositif sélecteur. Ce faisant, l'utilisation du deuxième dispositif sélecteur, capable de fournir le courant électrique élevé nécessaire pour modifier l'état de la cellule mémoire, est limitée à l'opération d'écriture.

L'invention permet l'utilisation de deux dispositifs sélecteurs possédant des propriétés différentes. Le premier matériau actif et le deuxième matériau actifs sont choisis de sorte à avoir un premier dispositif sélecteur adapté pour l'opération de lecture de l'état de la cellule mémoire et un deuxième dispositif sélecteur adapté pour l'opération d'écriture de la cellule mémoire.

Avantageusement, le dispositif sélecteur selon l'invention peut être utilisé dans toutes les mémoires de type « Crossbar », qui comportent l'utilisation d'un sélecteur, avec des architectures différentes telles que 1S2R ou 1S3R.

Outre les caractéristiques qui viennent d'être évoquées dans les paragraphes précédents, le dispositif sélecteur selon un aspect de l'invention peut présenter une ou plusieurs caractéristiques complémentaires parmi les suivantes, considérées individuellement ou selon toutes les combinaisons techniquement possibles :
- le premier matériau actif possède une première tension de seuil pour le passage d'un courant électrique et le deuxième matériau actif possède une deuxième tension de seuil pour le passage d'un courant électrique, la première tension de seuil étant inférieure à la deuxième tension de seuil ;
- le premier dispositif sélecteur est une diode, par exemple en Silicium polycristallin ;
- Le deuxième dispositif sélecteur est de type OTS ou de type FAST ou de type MIEC ;
- le deuxième dispositif sélecteur comprend en outre une première électrode du deuxième dispositif sélecteur et la première électrode du deuxième dispositif sélecteur et le deuxième matériau actif entourent le premier dispositif sélecteur ;
- la première électrode du deuxième dispositif sélecteur comprend une première et une deuxième partie de première électrode, le deuxième matériau actif comprend une première et une deuxième partie de matériau actif, les premières parties formant un premier angle avec le plan des couches du premier dispositif sélecteur et les deuxièmes parties formant un deuxième angle avec le plan des couches du premier dispositif sélecteur ;
- les premières parties sont sensiblement normales au plan des couches du premier dispositif sélecteur et les deuxièmes parties sont sensiblement parallèles au plan des couches du premier dispositif sélecteur.
- le dispositif sélecteur est un dispositif sélecteur de type backend.

Un autre objet de l'invention est un dispositif mémoire comprenant le dispositif sélecteur selon l'invention et une cellule mémoire résistive, le dispositif sélecteur et la cellule mémoire résistive étant connectés en série.

Selon un mode de réalisation, la cellule mémoire est de type mémoire résistive à changement de phase PCRAM ou mémoire résistive à conduction ionique CbRAM ou mémoire résistive à oxydes métalliques OxRAM.

Selon un mode de réalisation, le dispositif mémoire selon l'invention comporte une unique cellule mémoire.

Selon un autre mode de réalisation, le dispositif mémoire selon l'invention comporte deux cellules mémoires, chaque cellule mémoire résistive étant connectée en série avec le dispositif sélecteur.

Selon une mode de réalisation, le premier dispositif sélecteur est un dispositif front end et le deuxième dispositif sélecteur est un dispositif backend. Un autre objet de l'invention est un procédé de fabrication d'un dispositif sélecteur destiné à sélectionner une cellule mémoire résistive selon la revendication 12, comportant les étapes suivantes :
- dépôt d'un premier ensemble de couches comprenant une première et une deuxième couche d'électrode d'un premier dispositif sélecteur et une couche d'un premier matériau actif d'un premier dispositif sélecteur ;
- dépôt d'un deuxième ensemble de couches comprenant une première couche d'électrode d'un deuxième dispositif sélecteur et une couche d'un deuxième matériau actif d'un deuxième dispositif sélecteur ;
- connexion électrique de la première couche d'électrode du premier ensemble de couches et de la première couche d'électrode du deuxième ensemble de couches.
- Connexion électrique de la deuxième couche d'électrode du premier ensemble de couches et de la deuxième couche d'électrode du deuxième ensemble de couche.

Avantageusement, le procédé de fabrication selon l'invention comporte les étapes de :
- dépôt d'une couche électriquement conductrice destiné à connecter électriquement la première couche d'électrode du premier ensemble de couches et la première couche d'électrode du deuxième ensemble de couches.
- dépôt d'une deuxième couche d'électrode du deuxième dispositif sélecteur, la deuxième couche d'électrode du deuxième ensemble de couches étant connectée électriquement à la deuxième couche d'électrode du premier ensemble de couches.

Le dépôt de la couche électriquement conductrice et de la deuxième couche d'électrode du deuxième dispositif sélecteur permet de connecter en parallèle les deux dispositifs sélecteurs. Selon un mode de réalisation, la couche électriquement conductrice est une couche d'électrode d'une cellule mémoire résistive.

Avantageusement, le procédé selon l'invention permet d'obtenir un dispositif sélecteur comprenant un premier et un deuxième dispositif sélecteur. La connexion en parallèle des deux dispositifs sélecteurs permet, en choisissant de façon opportune le matériau actif compris dans chacun des deux sélecteurs, de prolonger la durée de vie du dispositif mémoire ainsi que sa fiabilité.

Le procédé selon l'invention comprend en outre une étape de gravure du premier ensemble de couches et l'étape de dépôt du deuxième ensemble de couches comprend en outre la gravure des couches du deuxième ensemble, les couches du deuxième ensemble entourant après leur gravure les couches du premier ensemble.

Selon un mode de réalisation le procédé selon l'invention comprend en outre une étape de dépôt et de gravure d'une couche diélectrique, la couche diélectrique entourant après gravure le premier ensemble de couches.

Selon un mode de réalisation, le procédé selon l'invention comprend en outre une étape de dépôt d'un troisième ensemble de couches comprenant un matériau actif de cellule mémoire résistive et une électrode de cellule mémoire résistive.

Selon un mode de réalisation l'étape de dépôt du troisième ensemble de couches est réalisée de sorte à disposer le troisième ensemble de couches au contact de la couche électriquement conductrice destinée à connecter une couche d'électrode du premier ensemble de couches et la première couche d'électrode du deuxième ensemble de couches.

Selon ce mode de réalisation, la couche électriquement conductrice destinée à connecter une couche d'électrode du premier ensemble de couches et la première couche d'électrode du deuxième ensemble de couches a aussi le rôle de couche d'électrode pour la cellule mémoire résistive.

Ce mode de réalisation permet de connecter en série la cellule mémoire résistive et le parallèle formé par les deux dispositifs sélecteurs.

Selon un mode de réalisation, la deuxième couche d'électrode du deuxième dispositif sélecteur est une ligne de mots ou une ligne de bits.

Avantageusement, le dépôt et la gravure des couches du deuxième ensemble de couches permet de réaliser un dispositif sélecteur comprenant un premier dispositif sélecteur et un deuxième dispositif sélecteur de façon compacte et reproductible. De plus, l'agencement du deuxième sélecteur entourant le premier sélecteur permet de réaliser efficacement une connexion en parallèle parmi le premier et deuxième dispositif sélecteur dans un dispositif intégré.

### BREVE DESCRIPTION DES FIGURES

Les figures sont présentées à titre indicatif et nullement limitatif de l'invention.
- La Figure 1 représente une caractéristique courant électrique tension appliquée pour un sélecteur de type backend ;
- La figure 2 représente un dispositif mémoire connu de l'homme du métier comprenant une cellule mémoire résistive connectée en série à un sélecteur de type diode ;
- La figure 3 représente une caractéristique courant électrique tension appliquée pour un dispositif mémoire de type 1S1R comprenant une cellule mémoire résistive et un dispositif sélecteur ;
- La figure 4 représente schématiquement un mode de réalisation du dispositif mémoire selon l'invention comprenant le dispositif sélecteur selon l'invention ;
- La figure 5 représente un mode de réalisation du dispositif sélecteur selon l'invention ;
- La figure 6 représente une caractéristique courant électrique tension appliquée pour une diode en Silicium polycristallin ;
- La figure 7 représente une caractéristique courant électrique tension appliquée pour un commutateur ovonique à seuil ou OTS ;
- La figure 8 représente une caractéristique courant électrique tension appliquée pour le dispositif mémoire selon l'invention ;
- Les figures 9 et 9b représentent schématiquement une vue en coupe du dispositif mémoire selon l'invention ;
- La figure 10 représente schématiquement le procédé de fabrication d'un dispositif sélecteur selon l'invention ;
- Les figures 11a à 11f représentent des vues en coupes des résultats obtenus après chaque étape du procédé de fabrication selon l'invention ;
- La figure 12 illustre un mode de réalisation d'un dispositif mémoire 200 en dehors de l'invention ;
- Les figures 13 à 15 illustrent des variantes de réalisation du dispositif mémoire de la figure 12 ;
- Les figures 16 à 18 illustrent d'autres modes de réalisation de dispositifs en dehors de l'invention.

L'invention et ses différentes applications seront mieux comprises à la lecture de la description qui suit et à l'examen des figures qui l'accompagnent.

### DESCRIPTION DETAILLEE D'UN MODE DE REALISATION DE L'INVENTION

Sauf précision contraire, un même élément apparaissant sur des figures différentes présente une référence unique.

[Fig 1] a déjà été décrite en référence à l'état de la technique.

[Fig 2] a déjà été décrite en référence à l'état de la technique.

[Fig 3] a déjà été décrite en référence à l'état de la technique.

[Fig 4] illustre schématiquement le dispositif mémoire M selon l'invention, comprenant une cellule mémoire CR et un dispositif sélecteur S selon l'invention, la cellule mémoire et le dispositif sélecteur étant connectés en série. Le dispositif sélecteur S selon l'invention comprend un premier dispositif sélecteur S1 et un deuxième dispositif sélecteur S2. Le premier dispositif sélecteur S1 et le deuxième dispositif sélecteur S2 sont connectés en parallèle. Chacun des deux dispositifs sélecteurs possède deux états, un premier état faiblement résistif et un deuxième état hautement résistif. La caractéristique courant électrique tension appliquée de chaque dispositif sélecteur montre une tension électrique de seuil au-delà de laquelle le dispositif sélecteur bascule dans son état faiblement résistif et fournit un courant électrique.

Avantageusement, le premier dispositif sélecteur et le deuxième dispositif sélecteur sont configurés pour avoir des tensions électriques de seuil différentes. Cela est possible par exemple grâce au choix de matériaux actifs différents pour les deux dispositifs.

Le premier dispositif sélecteur S1 comprend un premier matériau actif ayant une première tension électrique de seuil. Le deuxième dispositif sélecteur S2 comprend un deuxième matériau actif ayant une deuxième tension électrique de seuil. Le premier dispositif sélecteur S1 fournit dans son état faiblement résistif un courant électrique plus faible que le deuxième dispositif sélecteur S2.

Avantageusement, grâce à la connexion en parallèle des deux dispositifs sélecteurs S1 et S2, il est possible d'associer l'opération de lecture de l'état de la cellule mémoire résistive CR au premier dispositif sélecteur et l'opération de programmation de l'état de la cellule mémoire CR au deuxième dispositif sélecteur S2.

En effet, l'opération de lecture de l'état de la cellule mémoire résistive CR demande un courant électrique faible, généralement de l'ordre de 1 µA. Grâce au dispositif selon l'invention il est donc possible d'appliquer la première tension de seuil au dispositif sélecteur S et d'utiliser le courant électrique fourni par le premier dispositif sélecteur S1. Cela permet d'utiliser uniquement le premier dispositif sélecteur pour l'opération de lecture en évitant d'activer le deuxième dispositif sélecteur. L'opération de lecture n'entraîne aucune activation du deuxième dispositif sélecteur S2, en limitant sa détérioration et en augmentant la durée de vie et la fiabilité du dispositif. De plus, en utilisant un faible courant électrique pour l'opération de lecture, le dispositif selon l'invention limite la consommation d'énergie.

Ainsi, pour réaliser une opération d'écriture de la cellule mémoire résistive CR, il est possible d'appliquer la deuxième tension électrique de seuil, ce qui permet d'activer le deuxième dispositif sélecteur S2, en le plaçant dans son état faiblement résistif. La deuxième tension électrique de seuil étant plus élevée de la première tension électrique de seuil, le deuxième dispositif sélecteur S2 fournit un courant électrique très élevé, par exemple supérieur ou égale à 100 µA. Ce courant électrique élevé peut être opportunément utilisé pour modifier l'état de la cellule mémoire résistive.

Avantageusement, l'activation du deuxième dispositif sélecteur S2 est réalisée uniquement lors d'une opération d'écriture ou programmation. Les opérations d'écriture étant généralement moins fréquentes que les simples opérations de lecture, cela permet de réduire fortement la dégradation du deuxième dispositif sélecteur S2.

En d'autres termes, le dispositif mémoire résistive selon l'invention permet de faire face aux différentes contraintes rencontrées lors des opérations de lecture et d'écriture, tout en augmentant la fiabilité et le temps de vie du dispositif et en limitant la consommation en énergie.

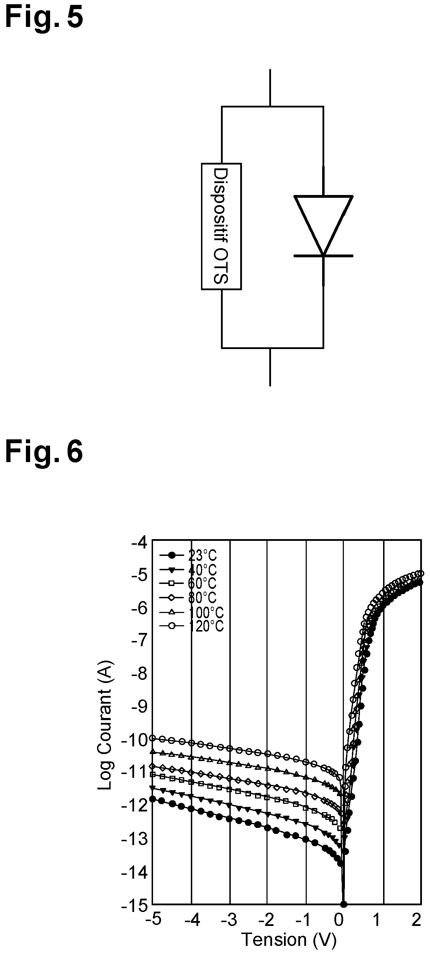

La figure 5 montre un mode de réalisation schématiquement particulier du dispositif sélecteur S selon l'invention. Selon ce mode de réalisation le premier dispositif sélecteur S1 est une diode et le deuxième dispositif sélecteur S2 est un dispositif sélecteur backend de type commutateur ovonique à seuil ou OTS.

La figure 6 illustre la caractéristique électrique d'une diode backend en température. On peut observer une tension de seuil autour de 1 V et des courants autour de 10µA pour une tension appliquée de 2V.

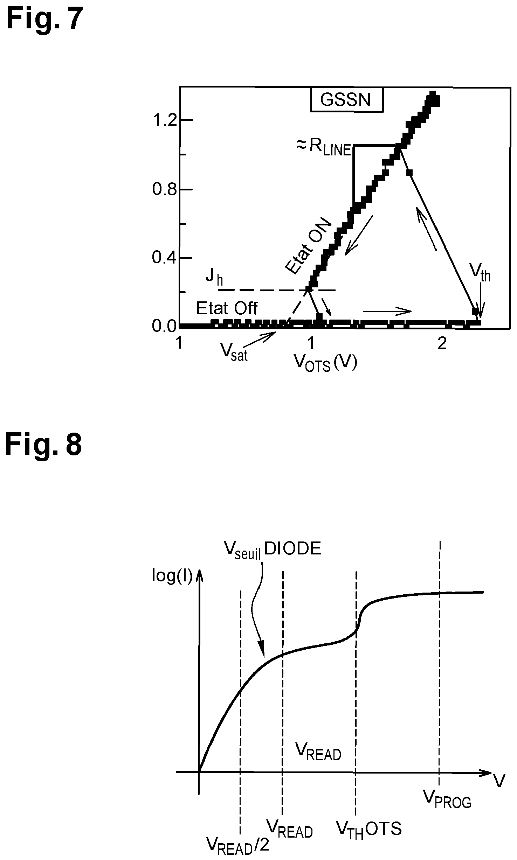

La figure 7 illustre la caractéristique électrique d'un sélecteur backend de type OTS. On voit que, pour des tensions appliquées supérieures à la tension de seuil V_{TH}, le sélecteur OTS passe de façon abrupte de l'état OFF à l'état conducteur ON.

Le choix d'une diode pour le premier dispositif sélecteur comporte plusieurs avantages.

Tout d'abord, la diode a une non-linéarité très importante et elle peut être activée à des tensions relativement faibles, avec une première tension de seuil de l'ordre de 1V.

A cause de la faible température de fabrication du backend, d'habitude inférieure à 500 °C, la résistance de l'état ON ou état faiblement résistif de la diode peut être très variable. Toutefois cela n'est plus un problème pour le dispositif selon l'invention, où l'état actif de la diode est réservé à la seule opération de lecture et donc à une simple distinction entre l'état ON et l'état OFF de la cellule mémoire. Avantageusement, le dispositif selon l'invention élimine la nécessité de maîtriser le courant fourni par une diode lors de l'opération d'écriture.

Par ailleurs, la résistance relativement élevée de la diode dans son état ON pose une grosse limite à la miniaturisation de la diode, ce qui n'est pas relevant si la diode est utilisée uniquement pour les opérations de lecture.

De plus, le courant sous-seuil d'une diode est très faible et compatible avec des courants de fuites très faibles.

Avantageusement, le dispositif selon l'invention utilise la diode uniquement pour une opération de lecture, les caractéristiques de la diode étant parfaitement adaptées pour cette opération, la diode peut être du type p-n ou p-i-n, obtenue par le dopage consécutif par implantation ionique.

Une diode à jonction p-n peut comprendre du Silicium polycristallin dopé B dans la zone « p » de la diode et du Silicium polycristallin dopé P dans la zone « n » de la diode.

Une diode à jonction p-i-n peut comprendre du Silicium polycristallin dopé B dans la zone « p » de la diode, du Silicium polycristallin intrinsèque dans la zone « i » et du Silicium polycristallin dopé P dans la zone « n » de la diode.

Le choix d'un sélecteur OTS de type backend pour le deuxième dispositif sélecteur S2 comporte aussi plusieurs avantages.

Tout d'abord la tension de seuil pour ce type de sélecteur backend est élevée, par exemple supérieure ou égale à 1V. Il existe une corrélation entre courant de fuite I_{LEAK} et tension de seuil V_{TH}. En effet, plus grande est la tension de seuil V_{TH} plus petite est I_{LEAK}. Idéalement, les courants de fuite sous-seuil doivent être très faibles pour réduire les pertes dans les cellules mémoires en dehors du dispositif mémoire sélectionné, au croisement de la ligne de mots et de la ligne de bits. Avantageusement, une tension de seuil élevée pour le deuxième dispositif sélecteur permet d'avoir une plus grande sélectivité du point mémoire à adresser et donc un I_{LEAK} plus faible.

De plus, un sélecteur de type OTS dans son état actif peut livrer une densité de courant élevé, en permettant donc la programmation de la cellule mémoire résistive CR. Cet aspect est très favorable au scaling du dispositif.

Le choix d'un dispositif de sélecteur de type OTS est donc idéal pour effectuer les opérations de programmation ou écriture de la cellule mémoire résistive.

La figure 8 illustre la caractéristique électrique du dispositif selon l'invention illustré à la figure 5. La tension de lecture V_{Read} doit être supérieure à la tension de seuil de la diode V_{seuil,DIODE}, de sorte à placer la diode dans son état actif, ou faiblement résistif. A la tension V_{Read} le dispositif sélecteur S2 reste dans son état hautement résistif, le seul courant électrique étant celui fourni par la diode. Cette configuration permet justement de lire l'état de la cellule mémoire. Si la mémoire est dans un état SET ou faiblement résistif avec une résistance de l'ordre de 10 kOhms, le courant électrique sera dominé par la résistance de la diode en série avec celle de la mémoire. On parle d'état SET du dispositif 1S1R. Si au contraire la mémoire est dans un état RESET, avec une résistance de l'ordre de 1MOhm, le courant électrique sera dominé par la résistance de la mémoire et donc très faible. On parle dans ce cas d'état SET du dispositif 1S1R

Selon un mode de réalisation, le dispositif comprend en outre un comparateur permettant de distinguer entre les deux états résistifs.

L'opération de programmation sera réalisée en appliquant la tension V_{Prog} au dispositif sélecteur. La tension V_{Prog} est plus élevée que la tension V_{th,OTS} du sélecteur backend de type OTS. La tension V_{Prog} est plus élevée que V_{read} et V_{seuil,Diode}. La tension V_{Prog} est suffisamment élevée pour changer l'état du sélecteur backend et le placer dans son état actif, ce qui permet au sélecteur de fournir des courants élevés. Ces courants sont suffisamment élevés pour permettre la programmation de la cellule mémoire résistive.

De façon identique à une structure « crossbar » standard, des générateurs de tension avec un contrôle de courant devront être mis en place pour piloter correctement la ligne de mots et la ligne de bits du dispositif adressé, au croisement des deux lignes.

La technique de polarisation d'une matrice formée par plusieurs dispositifs mémoire selon l'invention doit tenir en compte de la présence de deux tensions différentes de seuil (donc une tension pour la lecture, une tension pour la programmation). L'opération la plus impactée par la présence de courants de fuite est la lecture, ce qui limite donc la dimension maximale de la matrice. En effet l'opération de lecture repose sur la distinction entre un courant maximal, associé à l'état SET et un courant minimal, associé à l'état RESET. Le courant associé à l'état RESET est impacté par la présence de tous les dispositifs sur la même ligne de bits et la même ligne de mots du dispositif sélectionné polarisés à V/2 pour une polarisation de la matrice de type « V/2 ». Ce même courant peut également être impacté par tous les dispositifs de la matrice polarisés à V/3 pour une polarisation de la matrice de type « V/3 ».

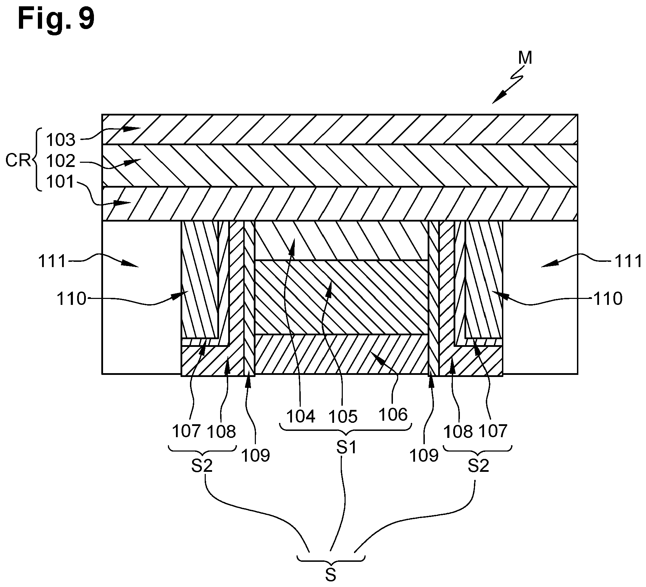

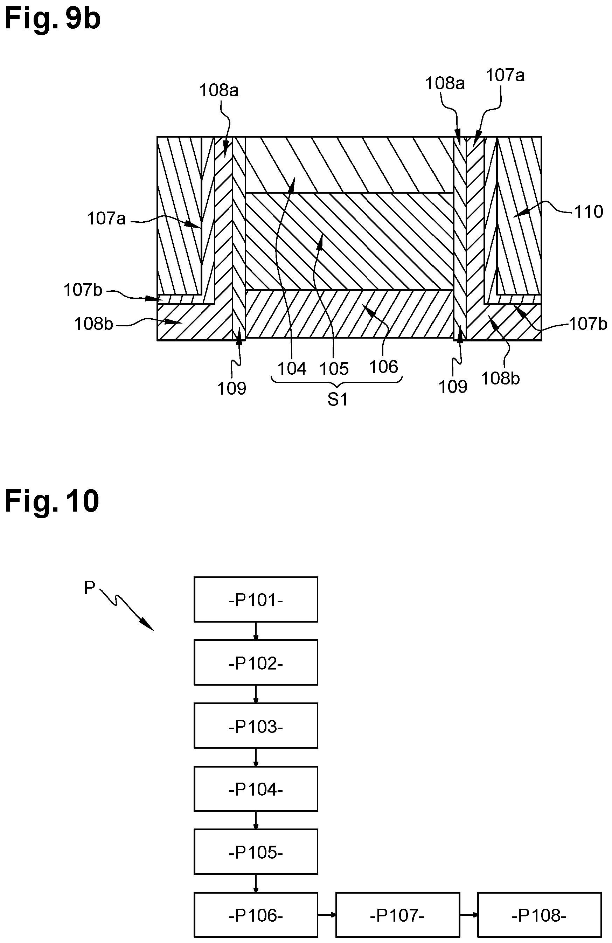

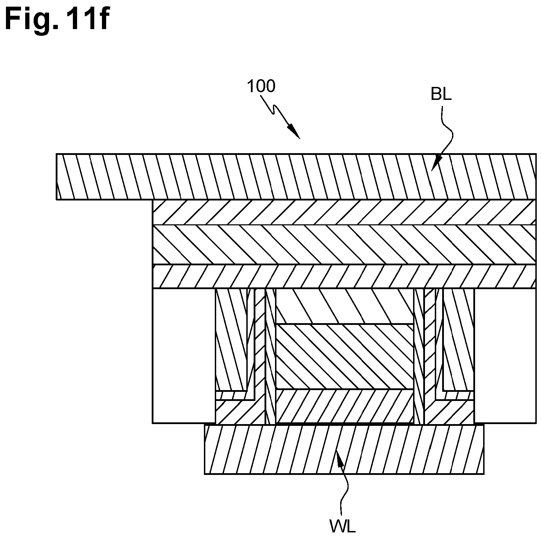

La figure 9 illustre un mode de réalisation du dispositif mémoire M selon l'invention, ledit dispositif comprenant :
- Une cellule mémoire résistive CR comprenant une première électrode de cellule mémoire 101, une deuxième électrode de cellule mémoire 103 et un matériau actif de cellule mémoire 102 ;
- Un premier dispositif sélecteur S1 comprenant une première électrode du premier dispositif sélecteur 104, une deuxième électrode du premier dispositif sélecteur 106 et un premier matériau actif 105 ;
- Un deuxième dispositif sélecteur S2 comprenant une première électrode du deuxième dispositif sélecteur 107 et un deuxième matériau actif 108 ; la deuxième électrode du deuxième dispositif sélecteur S2 n'est pas représentée sur cette figure et peut être réalisée comme illustré par la couche conductrice WL à la figure 11f ;
- Une couche diélectrique 109 configurée pour isoler électriquement le premier dispositif sélecteur S1 et le deuxième matériau actif 108 ;
- Une deuxième couche diélectrique 110 configurée pour isoler électriquement la première électrode du deuxième dispositif sélecteur 107 et une couche diélectrique de remplissage 111.

Selon un mode de réalisation, la première électrode de cellule mémoire 101 est disposée de sorte à connecter électriquement la première électrode du premier dispositif sélecteur 104 et la première électrode du deuxième dispositif sélecteur 107. Cet agencement permet d'obtenir une connexion en série entre la cellule mémoire résistive CR et le dispositif sélecteur S comprenant le premier dispositif sélecteur S1 et le deuxième dispositif sélecteur S2 qui sont en parallèle (S1 et S2). Selon un mode de réalisation, le dispositif M comprend en outre une électrode ou un élément conducteur électrique, qui n'est pas représentée sur la figure 9, connectant la deuxième électrode du premier dispositif sélecteur S2 et le deuxième matériau actif. Selon un mode de réalisation cette deuxième électrode est une ligne métallique de mots ou de bits, comme il est illustré à la figure 11f. Avantageusement, l'élément conducteur électrique connectant la deuxième électrode 106 du premier dispositif sélecteur S1 et le deuxième matériau actif 108 permet de réaliser la connexion en parallèle du premier dispositif sélecteur S1 et du deuxième dispositif sélecteur S2.

Selon le mode de réalisation illustré à la figure 9, les couches 109, 108, 107 et 110 sont déposées et ensuite gravées en couche intercalaire ou espaceur (ou « spacer » selon la terminologie anglaise). En d'autres termes, chaque couche est déposée et ensuite gravée selon la direction normale au plan de dépôt de la couche elle-même. La gravure peut comprendre toute l'épaisseur de la couche, comme dans le cas de la couche isolante électrique 109, qui est configurée comme une couche verticale normale au plan de dépôt des couches du premier dispositif sélecteur S1. Avantageusement la couche isolante électrique 109 permet d'isoler électriquement le premier dispositif sélecteur S1 et le deuxième matériau actif 108. Suite au processus de gravure, la couche isolante 109 entoure le premier dispositif sélecteur S1.

La gravure des couches 108 et 107 peut être partielle, comprenant seulement une partie de l'épaisseur des couches déposées. Il s'ensuit que les couches 107 et 108 ont une épaisseur variable selon la direction normale au plan de dépôt des couches du premier dispositif sélecteur S1. Par exemple, la vue en coupe de la figure 9 montre que le deuxième matériau actif 108 possède une section en forme de L, avec un pied d'épaisseur e. Avantageusement, le pied d'épaisseur e de la couche formant le deuxième matériau actif 108 permet la connexion en parallèle entre le premier dispositif sélecteur S1 et le deuxième dispositif sélecteur S2. Cela est possible grâce à la première électrode du deuxième dispositif sélecteur 107 et l'élément métallique connectant la deuxième électrode du premier sélecteur 106 et le deuxième matériau actif 108, ledit élément métallique n'étant pas représenté sur la figure 9. Selon un mode de réalisation illustré à la figure 11f, ledit élément métallique est une ligne de mots WL.

En d'autres termes, comme il est illustré à la figure 9b, la première électrode 107 du deuxième dispositif sélecteur comprend une première 107a et une deuxième partie 107b de première électrode, le deuxième matériau actif 108 comprend une première 108a et une deuxième partie 108b de matériau actif 108, les premières parties 107a, 108a formant un premier angle avec le plan des couches 104, 105, 106 du premier dispositif sélecteur S1 et les deuxièmes parties 107b, 108b formant un deuxième angle avec le plan des couches 104, 105, 106 du premier dispositif sélecteur S1. Le mode de réalisation illustré aux figures 9 et 9b comporte des premières parties 107a et 108a normales au plan des couches du premier dispositif sélecteur S1 et des deuxièmes parties 107b et 108b parallèles au plan des couches du premier dispositif sélecteur.

Selon le mode de réalisation représenté à la figure 9, les couches 107,108, 110 et 111 entourent le premier dispositif sélecteur S1. En d'autres termes, les couches 107 et 108 du deuxième dispositif sélecteur S2 entourent le premier dispositif sélecteur S1. Cela est possible grâce au fait que les couches comprises dans le deuxième dispositif sélecteur S2 sont au moins partiellement gravées en espaceur.

La figure 10 illustre schématiquement les étapes du procédé P de fabrication d'un dispositif sélecteur selon l'invention. Le procédé selon l'invention comprend une étape P101 de dépôt d'un premier ensemble de couches comprenant un premier dispositif sélecteur. Selon un mode de réalisation le premier dispositif sélecteur est une diode et le premier ensemble de couches comprend une première électrode du premier ensemble de couches, une deuxième électrode du premier ensemble de couches et un milieu actif du premier ensemble de couches, inséré parmi les deux électrodes. Selon un mode de réalisation, le milieu actif comprend du Silicium polycristallin.

Le procédé selon l'invention comprend en outre une étape P102 de gravure du premier ensemble de couches. Suite à cette étape de gravure le premier ensemble de couches peut avoir une section carrée, rectangulaire ou circulaire.

Lors de l'étape P103, une première couche diélectrique ou isolante électrique est déposée. Selon un mode de réalisation, l'étape P103 comprend en outre la gravure de la couche diélectrique en espaceur ou couche intercalaire ou « spacer » pour isoler électriquement le milieu actif du premier dispositif sélecteur et le milieu actif du deuxième dispositif sélecteur. Suite à l'étape de gravure en espaceur, la couche isolante entoure le premier dispositif sélecteur. En d'autres termes, la normale au plan de la couche isolante électrique est orientée selon une direction différente de la normale au plan des couches du premier ensemble de couches.

Lors de l'étape P104, un deuxième ensemble de couches est déposé. Le deuxième ensemble de couches comprend un deuxième matériau actif d'un deuxième dispositif sélecteur et une première électrode d'un deuxième dispositif sélecteur. L'étape 104 peut également comprendre la gravure en espaceur (ou « spacer » selon la terminologie anglaise) des couches du deuxième ensemble. Selon un mode de réalisation, avant de déposer la couche d'électrode, la couche comprenant le deuxième matériau actif est partiellement gravée, avec une épaisseur variable en fonction de la profondeur de gravure.

Selon un mode de réalisation, l'épaisseur variable du deuxième matériau actif forme un pourtour destiné à accueillir la première électrode du deuxième ensemble de couches, comme il est illustré aux figures 9 et 9b. De la même façon, la première électrode du deuxième dispositif sélecteur est gravée en espaceur ou « spacer », avec une épaisseur variable en fonction de la profondeur de gravure. Selon un mode de réalisation, la première électrode du deuxième dispositif sélecteur forme un pourtour destiné à accueillir une deuxième couche isolante, comme il est illustré aux figures 9 et 9b.

A l'issue de l'étape P104, le premier ensemble de couches comprenant le premier dispositif sélecteur est entouré par le deuxième ensemble de couches comprenant une couche d'électrode et une couche de matériau actif du deuxième dispositif sélecteur.

Le procédé selon l'invention comprend en outre une étape P105 de dépôt d'une couche électriquement conductrice destinée à connecter électriquement la première couche d'électrode du premier ensemble de couches et la première couche d'électrode du deuxième ensemble de couches.

Avantageusement, la couche électriquement conductrice déposée lors de l'étape P105 permet de réaliser la connexion en parallèle des deux dispositifs sélecteurs. Selon un mode de réalisation, la couche électriquement conductrice déposée lors de l'étape P105 est une couche d'électrode d'une cellule mémoire résistive, telle que la couche 101 illustrée à la figure 9.

Le procédé selon l'invention comprend en outre une étape P106 de dépôt d'une couche diélectrique de remplissage. Selon un mode de réalisation l'étape P106 comprend en outre la planarisation de la couche diélectrique de remplissage. Selon un mode de réalisation le diélectrique de remplissage entoure le deuxième dispositif sélecteur.

L'étape P107 comprend le dépôt d'un troisième ensemble de couches comprenant une électrode de cellule mémoire et un matériau actif de cellule mémoire résistive. Selon un mode de réalisation, le troisième ensemble de couches recouvre la couche électriquement conductrice déposée lors de l'étape P105, de sorte à former une cellule mémoire résistive. Selon un mode de réalisation, la cellule mémoire résistive ainsi formée comprend les couches 101, 102 et 103 illustrées à la figure 9.

En d'autres termes, l'étape de dépôt du troisième ensemble de couches P107 est réalisée de sorte à disposer le troisième ensemble de couches au contact de la couche électriquement conductrice destinée à connecter une couche d'électrode du premier ensemble de couches et la première couche d'électrode du deuxième ensemble de couches.

Selon ce mode de réalisation, la couche électriquement conductrice déposée lors de l'étape 105 a aussi la fonction de couche d'électrode pour la cellule mémoire résistive, dont la structure est complétée par les couches du troisième ensemble de couches.

Avantageusement, l'étape P107 permet de réaliser la connexion en série entre la cellule mémoire résistive et le parallèle formé par les deux dispositifs sélecteurs.

Selon un mode de réalisation, l'étape P107 comprend la gravure du troisième ensemble de couches comprenant la cellule mémoire résistive.

Le procédé selon l'invention comprend en outre une étape P108 de dépôt d'une deuxième couche d'électrode du deuxième dispositif sélecteur, la deuxième couche d'électrode du deuxième dispositif sélecteur étant connectée électriquement à une couche d'électrode du premier dispositif sélecteur.

Avantageusement, l'étape P108 permet de compléter la connexion en parallèle des deux dispositifs sélecteurs.

Selon un mode de réalisation, la deuxième couche d'électrode du deuxième dispositif sélecteur est une ligne de mots ou une ligne de bits.

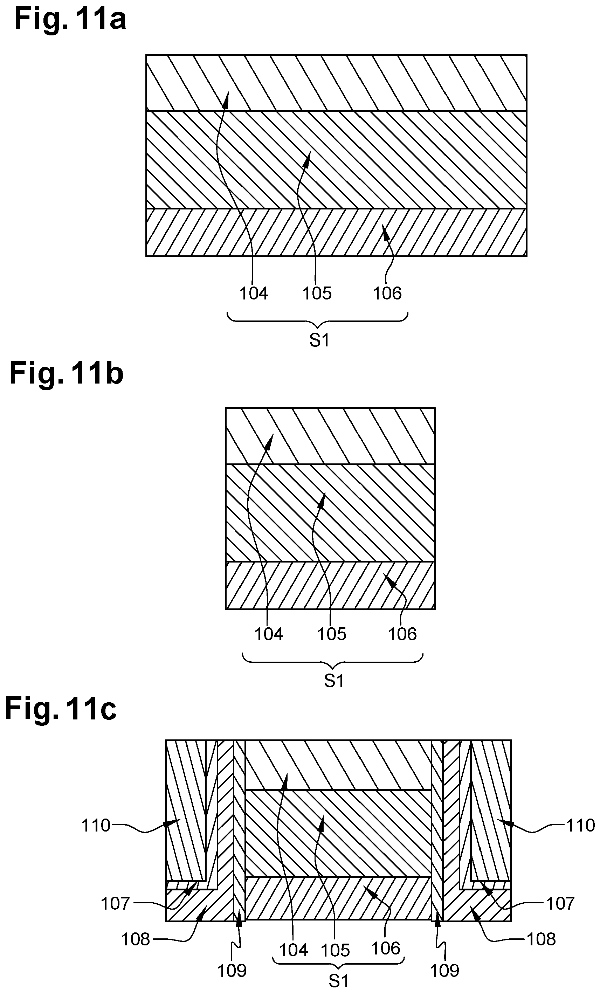

La figure 11a illustre schématiquement le résultat de l'étape P101 quand le premier dispositif sélecteur S1 est une diode poly-silicium. Dans ce cas le premier dispositif sélecteur S1 comprend une première électrode 104 de la diode, une deuxième électrode 106 de la diode et un matériau actif 105 comprenant du Silicium polycristallin. La figure 11b montre le résultat de l'étape P102, comportant la gravure du dispositif S1 de figure 11a, résultant en une diode à section carré, rectangulaire ou circulaire.

La figure 11c illustre le deuxième ensemble de couches entourant le premier ensemble de couches. Les couches 107,108,109 et 110 ont été décrites en relation aux figures 9 et 9b. Grâce aux étapes de gravure en « spacer », à la fois la couche de deuxième matériau actif 108 et la couche d'électrode 107 du deuxième ensemble de couches comprennent un pourtour permettant la connexion en parallèle du premier et du deuxième ensemble de couches. En d'autres termes, la vue en coupe de la figure 11c montre que le deuxième matériau actif 108 possède une section en forme de L comprenant un pied d'épaisseur e. Avantageusement, la forme en L du deuxième matériau actif 108 permet de connecter en parallèle le premier dispositif sélecteur S1 et du deuxième dispositif sélecteur S2.

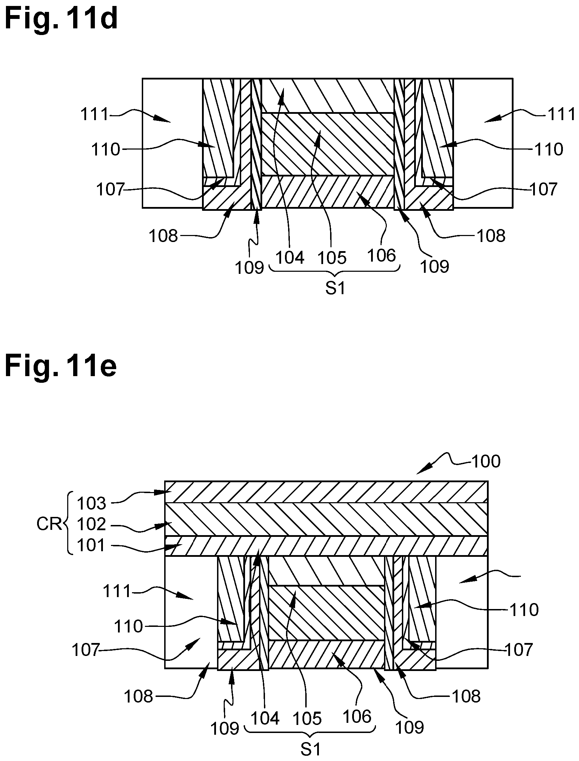

La figure 11d représente le résultat de l'étape P103, avec le dépôt d'une couche diélectrique 111 entourant le deuxième ensemble de couches.

La figure 11e représente le résultat de l'étape P107, avec le dépôt du troisième ensemble de couches comprenant la cellule mémoire résistive. Le troisième ensemble de couches comprend une électrode 101 de cellule mémoire CR ayant aussi la fonction de connexion électrique entre la première électrode 107 du deuxième dispositif sélecteur et la première électrode 104 du premier dispositif sélecteur. Cet agencement permet de réaliser la connexion en parallèle du premier et du deuxième ensemble de couches, correspondant au premier S1 et deuxième dispositif sélecteur S2.

La figure 11f représente le dispositif selon l'invention connecté à une ligne de bits BL et une ligne de mots WL, illustrant un mode de réalisation de l'étape P108. En particulier la ligne de mots WL permet de compléter la connexion parallèle entre le premier et le deuxième dispositif sélecteur tout en ayant la fonction de deuxième électrode du deuxième dispositif sélecteur.

Des exemples de matériaux actifs utilisés pour le deuxième dispositif sélecteur S2 selon l'invention sont : matériaux chalcogénure à base de Ge, Se, As, Si, Te, Sb, N, C, etc. ou ensemble de couches de plusieurs matériaux chalcogénure : Ge-Se, Ge-Se-Sb, As-Se-Ge-Si-N etc.

Les électrodes peuvent être par exemple en TiN, TaN, W, TiWN, TiCN, TiSiN, C, etc. ou ensemble de couches à base des mêmes matériaux ou autre matériaux conducteurs.

Les matériaux PCM utilisés en tant que matériaux actifs pour la cellule mémoire résistive CR sont également des matériaux à base d'alliages chalcogénure, ou mélanges ou ensemble de couches de ceux-ci : Ge-Sb-Te, Ga-Sb-Te, Ge-Te, Sb-Te, Ti-Sb-Te, Ti-Te.

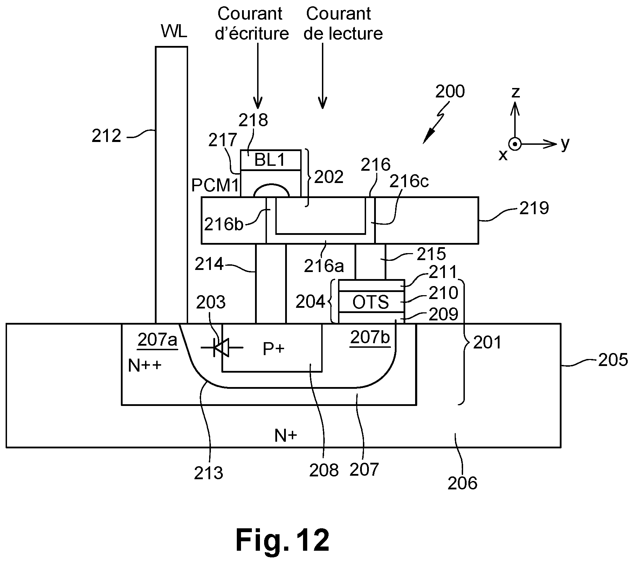

La figure 12 illustre un mode de réalisation d'un dispositif mémoire 200 en dehors de l'invention comportant un dispositif sélecteur 201 et une cellule mémoire résistive 202 de type PCM ou « PCRAM » pour « Phase-Change Random Access Memory ».

Le dispositif sélecteur 201 comporte une diode à jonction pn 203 (ici une diode à jonction P+-N++) et un sélecteur de type OTS 204.

La particularité de ce mode de réalisation consiste à partir d'une diode 203 enterrée en front end, par exemple dans un substrat SOI (Silicon On Insulator selon la terminologie anglaise) ou dans une couche de silicium 205 dopée de façon adaptée pour la réalisation de la diode 203.

La couche de silicium 205 comporte une partie 206 dopée N+ (i.e. fortement dopée N) avec un premier caisson intérieur 207 dopé N++ (i.e. très fortement dopé N, c'est-à-dire dopée d'avantage que la partie 206 dopée N+).

Un second caisson 208 dopé P+ (i.e. fortement dopé P) est réalisée à l'intérieur du premier caisson 207 dopé N++. Les deux caissons 207 et 208 permettent donc la formation de la diode 203 comportant une jonction P+/N++. Plus précisément, le second caisson 208 P+ est sensiblement centré à l'intérieur du premier caisson 207 N++ et l'une des parties 207a (ici à gauche sur le dessin) du premier caisson 207 permet la réalisation de la jonction P+/ N++ à son interface avec le second caisson P++ 208.

La partie supérieure des deux caissons 207 et 208 arrivent en surface de la couche de silicium 206 de façon à pouvoir assurer en back end des contacts au-dessus de la couche de silicium 206.

Le sélecteur OTS 204 est donc réalisé en back end sur la partie 207b (ici à droite sur le dessin) du premier caisson 207, les parties 207a et 207b étant de part et d'autre du second caisson P+ 208.

Le sélecteur OTS 204 comporte :
- une première électrode 209 réalisée en contact avec la surface supérieure de la partie 207b du premier caisson N++ 207,
- une couche active 210 réalisée par exemple dans matériau chalcogénure déposée sur la première électrode 209 et
- une deuxième électrode 211 réalisée sur la couche active 210.

Une ligne de mots 212 (ou WL « Wordline » selon la terminologie anglaise) est réalisée en contact avec la surface supérieure de la partie 207a du premier caisson P+ 208. Cette ligne de mots 212 peut être considérée comme une première électrode de la diode 203 et est reliée à la première électrode 209 du sélecteur OTS 204 via la zone N++ 207 (un chemin conducteur 213 est représenté de façon purement schématique afin d'illustrer cette liaison conductrice). Le chemin conducteur 213 est bien entendu légèrement résistif (du fait de la nature N++ de la zone 207) mais suffisante pour assurer une bonne conduction entre la ligne 212 et la première électrode 209.

Deux électrodes conductrices 214 et 215, par exemple métalliques, sont respectivement déposées sur le caisson P+ 208 de la diode 203 et sur la deuxième électrode 211 du sélecteur OTS 204. L'électrode 214 peut être considérée comme la seconde électrode de la diode 203.

Une électrode 216 en U comportant une base de U 216a dans le plan des couches et deux branches de U (respectivement 216b et 216c) sont agencées de sorte que la base du U 216a soit en contact respectivement avec les électrodes conductrices 214 et 215. Cette électrode en U, 216, est par exemple réalisée sous forme d'un liner déposé dans une tranchée gravé dans une zone isolante, et s'étend suivant la direction x perpendiculaire au plan de coupe de la figure 12.

La mémoire PCM 202 comporte une couche active 217 agencée au-dessus et en contact de la branche 216b de l'électrode en U 216. Cette couche active 217 est réalisée en un matériau à changement de phase, typiquement un matériau chalcogénure.

Une ligne de bit BL1 218 est agencée au-dessus et en contact de la couche active 217.

Selon ce mode de réalisation, la ligne de bit 218 fait office d'électrode supérieure pour la mémoire PCM 202 et la branche 216b de l'électrode en U 216 (et plus généralement l'électrode en U 216) fait office d'électrode inférieure pour la mémoire PCM 202.

Selon ce mode de réalisation, on constate que la seconde électrode 214 de la diode 203 et l'électrode supérieure 211 du sélecteur OTS 201 sont connectées électriquement par l'électrode en U 216.

Ainsi, le premier dispositif sélecteur formé par la diode 203 et le deuxième dispositif sélecteur 204 formé par le sélecteur OTS sont connectés en parallèle. En outre, la cellule mémoire PCM 202 est en série avec les deux sélecteurs 203 et 204 montés en parallèle.

L'intérêt d'un tel mode de réalisation se situe notamment au niveau technologique, en termes de fabrication, puisqu'il permet de séparer la fabrication du premier sélecteur (la diode 203) réalisé en front end du reste du dispositif réalisé en back end à des niveaux de métallisation plus élevés.

On notera par ailleurs que la diode est utilisée uniquement en lecture de sorte que sa dimension peut être réduite car elle ne nécessite pas de faire passer un courant important (i.e. courant d'écriture de la mémoire PCM) ; la zone N++ 206 doit être dimensionnée pour laisser passer le courant d'écriture venant du sélecteur OTS 204.

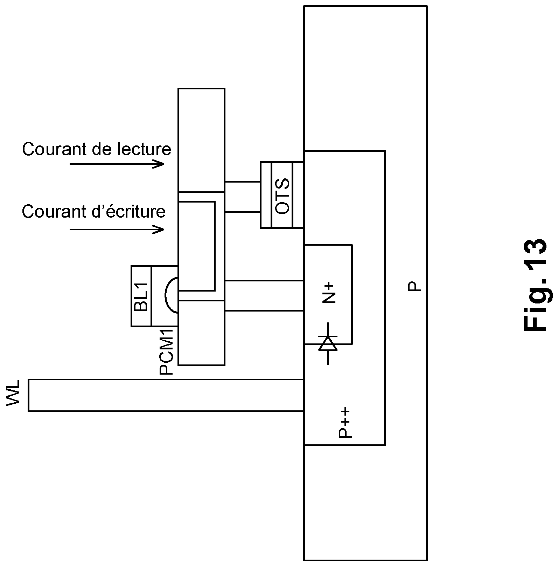

La figure 13 illustre un autre mode de réalisation d'un dispositif mémoire en dehors de l'invention. Ce dispositif est en tout point comparable à celui de la figure 12 à la différence que les dopages P et N de la zone back end sont inversés. Ainsi, le caisson 208 P+ devient un caisson N+ et le caisson 207 N++ devient un caisson P++. Plus généralement, il est possible d'inverser les dopages P et N.

La partie 206 dopée N+ dans laquelle sont enterrés les caissons devient indifféremment une zone P ou P+.

Au niveau du fonctionnement du dispositif mémoire, le seul changement consiste dans le sens du courant de lecture qui est inversé par rapport à celui de la figure 12, la diode de la figure 13 étant passante dans un sens inversé par rapport à son agencement de la figure 12.

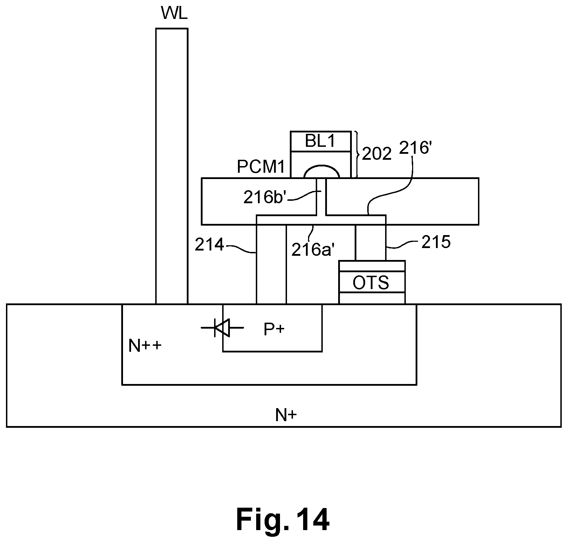

La figure 14 illustre une variante du dispositif 200 de la figure 12. La seule différence concerne l'électrode 216. On constate en effet que la branche 216c de l'électrode 216 en U n'a pas d'utilité dans le dispositif 200, si ce n'est que la réalisation d'une forme en U est facilement réalisable sous la forme d'un liner. Dans le mode de réalisation de la figure 14, l'électrode 216 en U est remplacée par une électrode 216' en forme de T inversé comportant une base 216a' dans le plan des couches et une branche perpendiculaire 216b'. Comme sur la figure 12, la base 216a' est agencée de sorte qu'elle soit en contact respectivement avec les électrodes conductrices 214 et 215 tandis que la branche 216b' fait office d'électrode inférieure pour la mémoire PCM 202. La couche active de la mémoire PCM est localisée au-dessus et en contact de la branche 216b'.

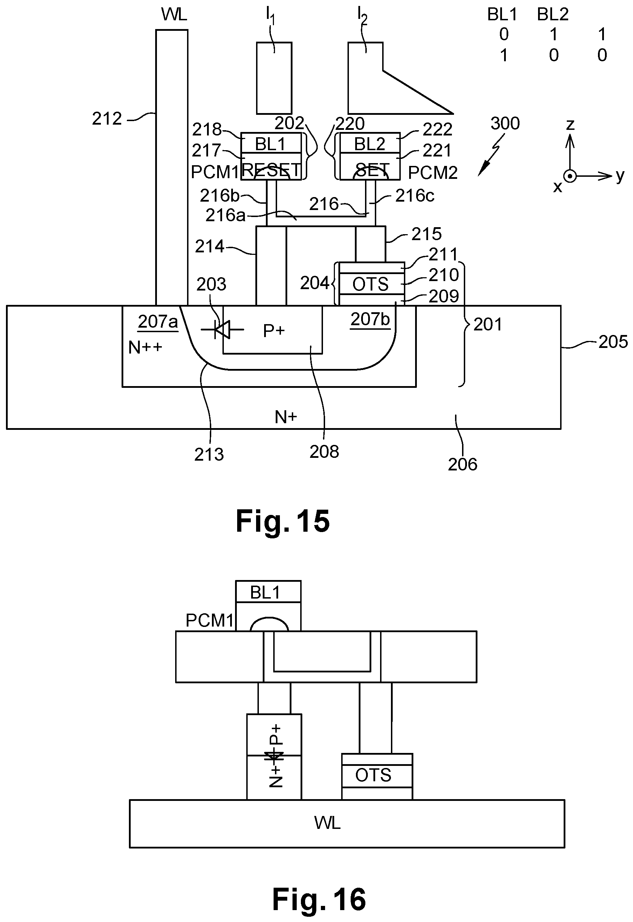

La figure 15 illustre une variante 300 du dispositif mémoire de la figure 12. Le dispositif 300 est identique au dispositif 200 de la figure 12 (les caractéristiques communes portent les mêmes numéros de référence) à la différence qu'il comporte en plus une deuxième cellule mémoire PCM 220 en plus de la première cellule mémoire PCM 202.

La cellule mémoire PCM 220 comporte une couche active 221 agencée au-dessus et en contact de la branche 216c de l'électrode en U 216. Cette couche active 221 est réalisée en un matériau à changement de phase, typiquement un matériau chalcogénure.

Une ligne de bit BL1 222 est agencée au-dessus et en contact de la couche active 221.

Selon ce mode de réalisation, la ligne de bit 222 fait office d'électrode supérieure pour la seconde mémoire PCM 220 et la branche 216c de l'électrode en U 216 (et plus généralement l'électrode en U 216) fait office d'électrode inférieure pour la seconde mémoire PCM 220.

L'avantage du mode de réalisation de la figure 15 est de tirer profit de l'existence de l'autre branche de l'électrode en U pour rajouter une autre mémoire PCM.

Selon ce mode de réalisation, chacune des deux cellules mémoire PCM 202 et 220 est montée en série avec les deux sélecteurs 203 et 204 de manière à former deux ensembles 1R1S montés en parallèle.

En présence des deux mémoires PCM, un des principes de l'invention peut être de programmer l'une dans l'état SET et l'autre dans l'état RESET.

Pour ce faire, on applique deux impulsions I1 et I2 différentes sur les électrodes supérieures 218 et 222 (i.e. les lignes de bit BL1 et BL2) respectives des cellules mémoires 202 et 220.

Pour mémoire, une cellule mémoire PCM utilise un matériau à changement de phase capable de basculer très rapidement et de façon réversible entre une phase amorphe et une phase cristalline. Or ces deux phases présentent de grandes différences de propriétés. La phase amorphe est notamment caractérisée par une résistivité électrique élevée, tandis que la phase cristalline présente une résistivité électrique beaucoup plus faible. Ainsi, le bit d'information est codé par la différence de résistivité entre l'état amorphe et l'état cristallin du matériau à changement de phase. Typiquement, l'état amorphe représente le niveau logique '0' et l'état cristallin représente le niveau logique '1'. La transition de l'état cristallin à l'état amorphe est obtenue en appliquant une courte impulsion de courant d'amplitude élevée, pour faire fondre localement le matériau cristallin et le rendre amorphe. La transition de l'état amorphe à l'état cristallin repose également sur un échauffement du matériau, à une température de cristallisation cependant moins élevée. Elle est obtenue en appliquant une impulsion de courant plus longue mais de plus faible amplitude.

En l'espèce, l'impulsion I1 appliquée sur la cellule 202 va rendre amorphe le matériau actif de la cellule 202 par échauffement. Le même phénomène va se produire avec l'impulsion I2 appliquée sur la cellule 220, la différence consistant en ce que l'impulsion I2 est plus longue que l'impulsion I1 et se poursuit avec une rampe de courant d'intensité moins élevé ; ainsi, la fin de l'impulsion I2 va permettre de cristalliser le matériau actif de la cellule 220. Ainsi, la première impulsion I1 va mettre la cellule 202 dans un état RESET (hautement résistif) tandis que l'impulsion I2 va mettre la cellule 220 dans un état SET (bassement résistif). On notera que l'écriture des cellules 202 et 220 se fait par le passage du courant dans le sélecteur OTS 201.

La lecture se fera quant à elle via le sélecteur formé par la diode 203. Quand on va « lire » la cellule 202, on mesurera une résistance élevée à ses bornes et quand on va « lire » la cellule 220, on mesurera une résistance plus faible à ses bornes.

Le dispositif 300 de la figure 15 est donc un dispositif du type « double cellule par bit » (ou « double cell per bit » ou DLC « Double-level cell » selon les terminologies anglaises) qui utilise la connaissance de deux états pour renforcer la probabilité de connaitre un état connu.

Selon ce mode de réalisation, l'autre branche de l'électrode est ainsi utilisée de façon pragmatique. On compare les deux informations pour avoir une information plus sure. Il est même possible d'avoir une autre information résistive entre les lignes de bit 212 et 222 (BL1 et BL2).

Une telle configuration est particulièrement utile pour des applications qui dépendent de façon critique de la rétention de l'information stockée dans la mémoire.

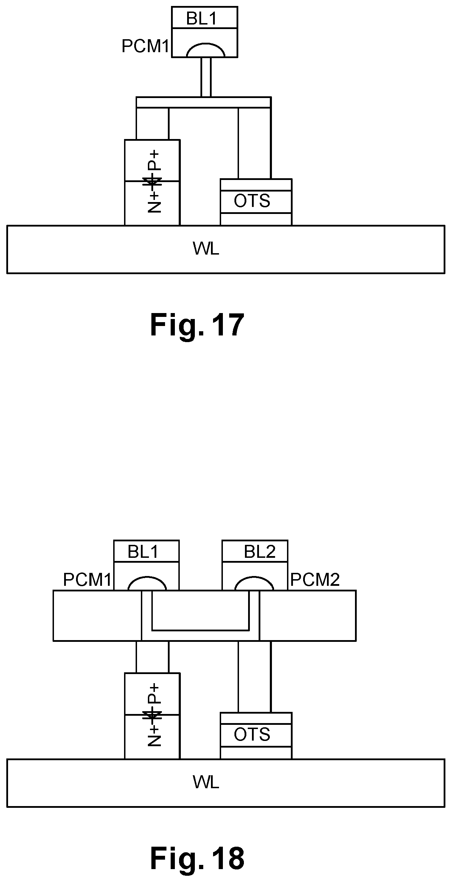

Les figures 16 à 18 illustrent d'autres modes de réalisation en dehors de l'invention dans lesquels les deux sélecteurs (diode et OTS) sont directement réalisés au même niveau métallique au-dessus d'une ligne de mot.

L'invention est particulièrement avantageuse dans le cas où le premier sélecteur est une diode et le deuxième sélecteur est un sélecteur de type OTS.

Certaines modes de réalisation ont été décrits dans le cas d'une cellule mémoire de type PCM mais l'invention pourrait également s'appliquer à d'autres cellules mémoires résistives telles que des OxRAM ou des CBRAM.

## Revendications

1. Dispositif sélecteur (S) destiné à sélectionner une cellule mémoire résistive (CR), comportant un premier dispositif sélecteur (S1) comprenant un premier matériau actif (105) et un deuxième dispositif sélecteur (S2) comprenant un deuxième matériau actif (108), le premier dispositif sélecteur (S1) et le deuxième dispositif sélecteur (S2) étant connectés en parallèle, le premier dispositif sélecteur (S1) étant configuré pour fournir un courant électrique adapté à une lecture d'un état de la cellule mémoire résistive (CR) et le deuxième dispositif sélecteur (S2) étant configuré pour fournir un courant électrique adapté à une écriture d'un état de la cellule mémoire résistive (CR),
**caracterisé en ce que** le deuxième dispositif sélecteur (S2) est agencé pour entourer le premier dispositif sélecteur (S1).

2. Dispositif sélecteur (S) selon la revendication précédente **caractérisé en ce que** le premier matériau actif (105) possède une première tension de seuil pour le passage d'un courant électrique et le deuxième matériau actif (108) possède une deuxième tension de seuil pour le passage d'un courant électrique, la première tension de seuil étant inférieure à la deuxième tension de seuil.

3. Dispositif sélecteur (S) selon l'une des revendications précédentes **caractérisé en ce que** le premier dispositif sélecteur (S1) est une diode.

4. Dispositif sélecteur (S) selon l'une des revendications précédentes **caractérisé en ce que** le deuxième dispositif sélecteur (S2) est un commutateur ovonique à seuil ou un sélecteur à seuil supra-linéaire assisté par champ ou un sélecteur à conduction électrique mixte ionique-électronique.

5. Dispositif sélecteur (S) selon l'une des revendications précédentes **caractérisé en ce que** le deuxième dispositif sélecteur (S2) comprend en outre une première électrode (107) du deuxième dispositif sélecteur et **en ce que** la première électrode (107) du deuxième dispositif sélecteur (S2) et le deuxième matériau actif (108) entourent le premier dispositif sélecteur (S1).

6. Dispositif sélecteur (S) selon la revendication précédente **caractérisé en ce que** la première électrode (107) du deuxième dispositif sélecteur comprend une première (107a) et une deuxième partie (107b) de première électrode, le deuxième matériau actif (108) comprend une première (108a) et une deuxième partie (108b) de matériau actif (108), les premières parties (107a, 108a) formant un premier angle avec le plan des couches (104, 105, 106) du premier dispositif sélecteur (S1) et les deuxièmes parties (107b, 108b) formant un deuxième angle avec le plan des couches (104, 105, 106) du premier dispositif sélecteur (S1).

7. Dispositif sélecteur (S) selon la revendication précédente **caractérisé en ce que** les premières parties (107a, 108a) sont sensiblement normales au plan des couches (104, 105, 106) du premier dispositif sélecteur (S1) et les deuxièmes parties (107b, 108b) sont sensiblement parallèles au plan des couches (104, 105, 106) du premier dispositif sélecteur.

8. Dispositif mémoire (M, 100) **caractérisé en ce qu'**il comprend le dispositif sélecteur (S) selon l'une des revendications précédentes et au moins une cellule mémoire résistive (CR), le dispositif sélecteur (S) et la cellule mémoire résistive (CR) étant connectés en série.

9. Dispositif mémoire (M, 100) selon la revendication précédente **caractérisé en ce qu'**il comporte une unique cellule mémoire (CR).

10. Dispositif mémoire (M) selon la revendication 8 **caractérisé en ce qu'**il comporte deux cellules mémoires (CR), chaque cellule mémoire résistive (CR) étant connectée en série avec le dispositif sélecteur (S).

11. Dispositif mémoire (M, 100) selon l'une des revendications 8 à 10 **caractérisé en ce que** le premier dispositif sélecteur (S1) est un dispositif front end et le deuxième dispositif sélecteur (S2) est un dispositif backend.

12. Procédé (P) de fabrication d'un dispositif sélecteur (S) destiné à sélectionner une cellule mémoire résistive (CR), comportant les étapes suivantes :
• Dépôt (P101) d'un premier ensemble de couches comprenant une première (104) et une deuxième (106) couche d'électrode d'un premier dispositif sélecteur (S1) et une couche (105) d'un premier matériau actif du premier dispositif sélecteur (S1) suivi d'une gravure (P102) du premier ensemble de couches ;
• Dépôt (P104) d'un deuxième ensemble de couches comprenant une première (107) et une deuxième couche d'électrode d'un deuxième dispositif sélecteur (S2) et une couche (108) d'un deuxième matériau actif du deuxième dispositif sélecteur (S2) suivi d'une gravure du deuxième ensemble de couches;
• Connexion électrique de la première couche d'électrode (104) du premier ensemble de couches et de la première couche d'électrode (107) du deuxième ensemble de couches ;
• Connexion électrique de la deuxième couche d'électrode (106) du premier ensemble de couches et de la deuxième couche d'électrode du deuxième ensemble de couches,
**caractérisé en ce que** les couches du deuxième ensemble entourent après leur gravure les couches du premier ensemble.

13. Procédé (P) de fabrication d'un dispositif sélecteur (S) selon la revendication précédente **caractérisé en ce qu'**il comporte les étapes de :
- Dépôt (P105) d'une couche électriquement conductrice (101) destiné à connecter électriquement la première couche d'électrode (104) du premier ensemble de couches et la première couche d'électrode (107) du deuxième ensemble de couches ;
- Dépôt (P108) de la deuxième couche d'électrode du deuxième dispositif sélecteur, la deuxième couche d'électrode du deuxième dispositif sélecteur étant connectée électriquement à la deuxième couche d'électrode (106) du premier ensemble de couches.

14. Procédé (P) de fabrication d'un dispositif sélecteur (S) selon la revendication 12 ou la revendication 13 **caractérisé en ce qu'**il comprend en outre une étape de dépôt et de gravure (P103) d'une couche diélectrique (109), la couche diélectrique (109) entourant après sa gravure le premier ensemble de couches

15. Procédé (P) de fabrication d'un dispositif sélecteur (S) selon l'une des revendications 12 à 14 **caractérisé en ce qu'**il comprend en outre une étape de dépôt (P107) d'un troisième ensemble de couches comprenant un matériau actif (102) de cellule mémoire résistive (CR) et une électrode (103) de cellule mémoire résistive (CR).

16. Procédé (P) de fabrication d'un dispositif sélecteur (S) selon la revendication précédente **caractérisé en ce que** l'étape de dépôt (P107) du troisième ensemble de couches est réalisée de sorte à disposer le troisième ensemble de couches au contact de la couche électriquement conductrice (101) destinée à connecter la première couche d'électrode (104) du premier ensemble de couches et la première couche d'électrode (107) du deuxième ensemble de couches.

## Patentansprüche

1. Auswahlvorrichtung (S) zum Auswählen einer resistiven Speicherzelle (CR), mit einer ersten Auswahlvorrichtung (S1), die ein erstes aktives Material (105) umfasst, und einer zweiten Auswahlvorrichtung (S2), die ein zweites aktives Material (108) umfasst, wobei die erste Auswahlvorrichtung (S1) und die zweite Auswahlvorrichtung (S2) parallel geschaltet sind, wobei die erste Auswahlvorrichtung (S1) so gestaltet ist, dass sie einen elektrischen Strom liefert, der zum Ablesen eines Zustands der resistiven Speicherzelle (CR) geeignet ist, und die zweite Auswahlvorrichtung (S2) so gestaltet ist, dass sie einen elektrischen Strom liefert, der zum Schreiben eines Zustands der resistiven Speicherzelle (CR) geeignet ist,
**dadurch gekennzeichnet, dass** die zweite Auswahlvorrichtung (S2) so angeordnet ist, dass sie die erste Auswahlvorrichtung (S1) umgibt.

2. Auswahlvorrichtung (S) nach dem vorhergehenden Anspruch, **dadurch gekennzeichnet, dass** das erste aktive Material (105) eine erste Schwellenspannung für den Durchgang eines elektrischen Stroms hat und das zweite aktive Material (108) eine zweite Schwellenspannung für den Durchgang eines elektrischen Stroms hat, wobei die erste Schwellenspannung niedriger als die zweite Schwellenspannung ist.

3. Auswahlvorrichtung (S) nach einem der vorhergehenden Ansprüche, **dadurch gekennzeichnet, dass** die erste Auswahlvorrichtung (S1) eine Diode ist.

4. Auswahlvorrichtung (S) nach einem der vorhergehenden Ansprüche, **dadurch gekennzeichnet, dass** die zweite Auswahlvorrichtung (S2) ein Dünnschicht-Schwellwertschalter oder ein feldunterstützter supralinearer Schwellwertschalter oder ein gemischt ionisch-elektronischer elektrisch leitender Schalter ist.

5. Auswahlvorrichtung (S) nach einem der vorhergehenden Ansprüche, **dadurch gekennzeichnet, dass** die zweite Auswahlvorrichtung (S2) außerdem eine erste Elektrode (107) der zweiten Auswahlvorrichtung umfasst und dass die erste Elektrode (107) der zweiten Auswahlvorrichtung (S2) und das zweite aktive Material (108) die erste Auswahlvorrichtung (S1) umschließen.

6. Auswahlvorrichtung (S) nach dem vorhergehenden Anspruch, **dadurch gekennzeichnet, dass** die erste Elektrode (107) der zweiten Auswahlvorrichtung einen ersten (107a) und einen zweiten Abschnitt (107b) der ersten Elektrode umfasst, wobei das zweite aktive Material (108) einen ersten (108a) und einen zweiten Abschnitt (108b) des aktiven Materials (108) umfasst, wobei die ersten Abschnitte (107a, 108a) einen ersten Winkel mit der Ebene der Schichten (104, 105, 106) der ersten Auswahlvorrichtung (S1) bilden und die zweiten Abschnitte (107b, 108b) einen zweiten Winkel mit der Ebene der Schichten (104, 105, 106) der ersten Auswahlvorrichtung (S1) bilden.

7. Auswahlvorrichtung (S) nach dem vorhergehenden Anspruch, **dadurch gekennzeichnet, dass** die ersten Abschnitte (107a, 108a) im Wesentlichen senkrecht zur Ebene der Schichten (104, 105, 106) der ersten Auswahlvorrichtung (S1) sind und die zweiten Abschnitte (107b, 108b) im Wesentlichen parallel zur Ebene der Schichten (104, 105, 106) der ersten Auswahlvorrichtung sind.

8. Speichervorrichtung (M, 100), **dadurch gekennzeichnet, dass** sie die Auswahlvorrichtung (S) nach einem der vorhergehenden Ansprüche und mindestens eine resistive Speicherzelle (CR) umfasst, wobei die Auswahlvorrichtung (S) und die resistive Speicherzelle (CR) in Reihe geschaltet sind.

9. Speichervorrichtung (M, 100) nach dem vorhergehenden Anspruch, **dadurch gekennzeichnet, dass** sie eine einzige Speicherzelle (CR) umfasst.

10. Speichervorrichtung (M) nach Anspruch 8, **dadurch gekennzeichnet, dass** sie zwei Speicherzellen (CR) umfasst, wobei jede resistive Speicherzelle (CR) mit der Auswahlvorrichtung (S) in Reihe geschaltet ist.

11. Speichervorrichtung (M, 100) nach einem der Ansprüche 8 bis 10, **dadurch gekennzeichnet, dass** die erste Auswahlvorrichtung (S1) eine Frontend-Vorrichtung und die zweite Auswahlvorrichtung (S2) eine Backend-Vorrichtung ist.

12. Verfahren (P) zur Herstellung einer Auswahlvorrichtung (S) zum Auswählen einer resistiven Speicherzelle (CR), das die folgenden Schritte umfasst:
- Auftragen (P101) einer ersten Einheit von Schichten, die eine erste (104) und eine zweite (106) Elektrodenschicht einer ersten Auswahlvorrichtung (S1) und eine Schicht (105) eines ersten aktiven Materials der ersten Auswahlvorrichtung (S1) umfasst, gefolgt von einem Ätzen (P102) der ersten Einheit von Schichten;
- Auftragen (P104) einer zweiten Einheit von Schichten, die eine erste (107) und eine zweite Elektrodenschicht einer zweiten Auswahlvorrichtung (S2) und eine Schicht (108) eines zweiten aktiven Materials der zweiten Auswahlvorrichtung (S2) umfasst, gefolgt von einem Ätzen der zweiten Einheit von Schichten;
- Elektrische Verbindung der ersten Elektrodenschicht (104) der ersten Einheit von Schichten und der ersten Elektrodenschicht (107) der zweiten Einheit von Schichten;
- Elektrische Verbindung der zweiten Elektrodenschicht (106) der ersten Einheit von Schichten und der zweiten Elektrodenschicht der zweiten Einheit von Schichten,
**dadurch gekennzeichnet, dass**
die Schichten der zweiten Einheit nach dem Ätzen die Schichten der ersten Einheit umschließen.

13. Verfahren (P) zur Herstellung einer Auswahlvorrichtung (S) nach dem vorhergehenden Anspruch, **dadurch gekennzeichnet, dass** es die folgenden Schritte umfasst:
- Auftragen (P105) einer elektrisch leitfähigen Schicht (101) zum elektrischen Verbinden der ersten Elektrodenschicht (104) der ersten Einheit von Schichten und der ersten Elektrodenschicht (107) der zweiten Einheit von Schichten;
- Auftragen (P108) der zweiten Elektrodenschicht der zweiten Auswahlvorrichtung, wobei die zweite Elektrodenschicht der zweiten Auswahlvorrichtung elektrisch mit der zweiten Elektrodenschicht (106) der ersten Einheit von Schichten verbunden ist.

14. Verfahren (P) zur Herstellung einer Auswahlvorrichtung (S) nach Anspruch 12 oder Anspruch 13, **dadurch gekennzeichnet, dass** es außerdem einen Schritt des Auftragens und Ätzens (P103) einer dielektrischen Schicht (109) umfasst, wobei die dielektrische Schicht (109) nach ihrem Ätzen die erste Einheit von Schichten umgibt.

15. Verfahren (P) zur Herstellung einer Auswahlvorrichtung (S) nach einem der Ansprüche 12 bis 14, **dadurch gekennzeichnet, dass** es außerdem einen Schritt des Auftragens (P107) einer dritten Einheit von Schichten umfasst, die ein aktives Material (102) einer resistiven Speicherzelle (CR) und eine Elektrode (103) einer resistiven Speicherzelle (CR) umfasst.

16. Verfahren (P) zur Herstellung einer Auswahlvorrichtung (S) nach dem vorhergehenden Anspruch, **dadurch gekennzeichnet, dass** der Schritt des Auftragens (P107) der dritten Einheit von Schichten so durchgeführt wird, dass die dritte Einheit von Schichten in Kontakt mit der elektrisch leitenden Schicht (101) angeordnet wird, die dazu bestimmt ist, die erste Elektrodenschicht (104) der ersten Einheit von Schichten und die erste Elektrodenschicht (107) der zweiten Einheit von Schichten zu verbinden.

## Claims

1. Selector device (S) intended to select a resistive memory cell **characterised in that** it comprises a first selector device (S1) comprising a first active material (105) and a second selector device (S2) comprising a second active material (108), the first selector device (S1) and the second selector device (S2) being connected in parallel, the first selector device (S1) being configured to supply an electric current suited to a reading of a state of the resistive memory cell and the second selector device (S2) being configured to supply an electric current suited to a writing of a state of a resistive memory cell (CR) **characterized in that** the second selector device (S2) is arranged to surround the first selector device (S1).

2. Selector device (S) according to the preceding claim **characterised in that** the first active material (105) has a first threshold voltage for the passage of an electric current and the second active material (108) has a second threshold voltage for the passage of an electric current, the first threshold voltage being lower than the second threshold voltage.

3. Selector device (S) according to one of the preceding claims **characterised in that** the first selector device (S1) is a diode.

4. Selector device (S) according to one of the preceding claims **characterised in that** the second selector device (S2) is an ovonic threshold switch or a field assisted superlinear threshold selector or a mixed ionic electronic conduction selector.

5. Selector device (S) according to one of the preceding claims **characterised in that** the second selector device (S2) further comprises a first electrode (107) of the second selector device and **in that** the first electrode (107) of the second selector device (S2) and the second active material (108) surround the first selector device (S1).

6. Selector device (S) according to the preceding claim **characterised in that** the first electrode (107) of the second selector device comprises a first (107a) and a second part (107b) of first electrode, the second active material (108) comprises a first (108a) and a second part (108b) of active material (108), the first parts (107a, 108a) forming a first angle with the plane of the layers (104, 105, 106) of the first selector device (S1) and the second parts (107b, 108b) forming a second angle with the plane of the layers (104, 105, 106) of the first selector device (S1).

7. Selector device (S) according to the preceding claim **characterised in that** the first parts (107a, 108a) are substantially normal to the plane of the layers (104, 105, 106) of the first selector device (S1) and the second parts (107b, 108b) are substantially parallel to the plane of the layers (104, 105, 106) of the first selector device.

8. Memory device (M, 100) **characterised in that** it comprises the selector device (S) according to one of the preceding claims and at least one resistive memory cell (CR), the selector device (S) and the resistive memory cell (CR) being connected in series.

9. Memory device (M, 100) according to the preceding claim **characterised in that** it comprises a single memory cell (CR).

10. Memory (M) device according to claim 8 **characterised in that** it comprises two memory cells (CR) each resistive memory cell (CR) being connected in series with the selector device (S).

11. Memory device (M, 100) according to one of claims 8 to 10 **characterised in that** the first selector device (S1) is a front end device and the second selector device (S2) is a back end device.

12. Method (P) for manufacturing a selector device (S) intended to select a resistive memory cell (CR) comprising the following steps:
• Depositing (P101) a first set of layers comprising a first (104) and a second (106) electrode layer of a first selector device (S1) and a layer (105) of a first active material of the first selector device (S1) followed by an etching (P102) of the first set of layers;
• Depositing (P104) a second set of layers comprising a first (107) and a second electrode layer of a second selector device (S2) and a layer (108) of a second active material of the second selector device followed by an etching of the second set of layers;
• Electrically connecting the first electrode layer (104) of the first set of layers and the first electrode layer (107) of the second set of layers.
• Electrically connecting the second electrode layer (106) of the first set of layers and the second electrode layer of the second set of layers
**characterized in that** the layers of the second set surround, after their etching, the layers of the first set.

13. Method (P) for manufacturing a selector device (S) according to the preceding claim **characterised in that** it comprises the steps of:
• Depositing (P105) an electrically conductive layer (101) intended to connect electrically the first electrode layer (104) of the first set of layers and the first electrode layer (107) of the second set of layers.
• Depositing (P108) the second electrode layer of the second selector device, the second electrode layer of the second selector device being electrically connected to the second electrode layer (106) of the first set of layers.

14. Method (P) for manufacturing a selector device (S) according to claim 12 or claim 13 **characterised in that** it further comprises a step of deposition and of etching (P103) of a dielectric layer (109), the dielectric layer (109) surrounding after its etching the first set of layers.

15. Method (P) for manufacturing a selector device according to one of claims 12 to 14 **characterised in that** it further comprises a step of deposition (P107) of a third set of layers comprising a resistive memory cell active material (102) and a resistive memory cell (CR) electrode (103).

16. Method (P) for manufacturing a selector device (S) according to the preceding claim **characterised in that** step of deposition (P107) of the third set of layers is carried out so as to arrange the third set of layers in contact with the electrically conductive layer (101) intended to connect the first electrode layer(104) of the first set of layers and the first electrode layer (107) of the second set of layers.
